# EUROPEAN PATENT SPECIFICATION

(11) **EP 0 269 294 B1**
(45) Date of publication and mention of the grant of the patent: **21.08.1996**
(21) Application number: 87309773.7
(22) Date of filing: 04.11.1987
(51) Int. Cl.: H01L 21/18

(54) **Method of manufacturing a bonded structure type semiconductor substrate**
Verfahren zur Herstellung eines Halbleitersubstrats von zusammengesetzter Art
Méthode de fabrication d'un substrat semi-conducteur du type à structure jointe

(30) Priority: 05.11.1986 JP 261849/86
(43) Date of publication of application: 01.06.1988
(73) Proprietor: KABUSHIKI KAISHA TOSHIBA, Kawasaki-shi, Kanagawa-ken 210 (JP)
(72) Inventor: Hoshi, Tadahide C/o Patent Division k.K. Toshiba, Tokyo 105 (JP)
(74) Representative: Freed, Arthur Woolf

(56) References cited:
- EP-A- 0 192 229
- EP-A- 0 192 229
- JAPANESE JOURNAL OF APPLIED PHYSICS, vol. 19, supplement 19-1, 1980, pages 61-64, Tokyo, JP; K. YAGI et al.: "Low-frequency low-noise transistors fabricated by double ion implantation"
- EXTENDED ABSTRACTS, vol. 86-1, no. 1, May 1986, pages 337-338, abstract no. 232, Pennington, New Jersey, US; M. SHIMBO et al.: "A newly developed silicon to silicon direct adhesion method"
- S.M.Sze, "Physics of Semiconductor Devices", 2nd edition, New York: Wiley, 1981, p.32, p.70,71
- S.M.Sze, "Semiconductor Devices, Physics and Technology", New York: Wiley, 1985, p.415-426

## Description

The present invention relates to a method of manufacturing a bonded structure type semiconductor substrate and, more particularly, to a method of manufacturing a bonded structure type semiconductor substrate which can prevent generation of micro voids at a bonding interface.

Conventionally, as disclosed for example in EP-A-0192229, a bonded structure type semiconductor substrate has been proposed in which a P⁺-type semiconductor substrate having a low specific resistance is bonded to the surface of an N⁺-type ion-implanted layer formed on an N⁻-type semiconductor substrate having a high specific resistance. The bonded structure type semiconductor substrate is manufactured as follows:

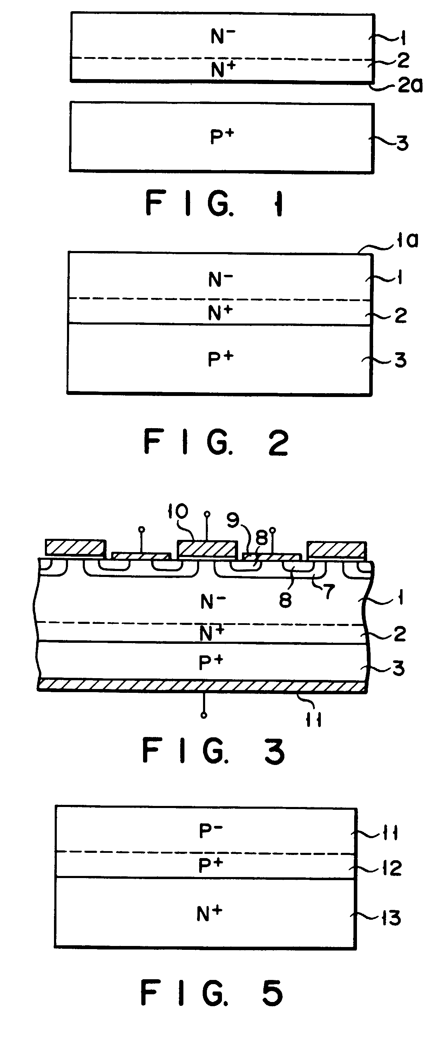

As is shown in Fig. 1, phosphorus ions are implanted in high resistance N⁻-type substrate 1 having a specific resistance of about 10 Ω·cm or more, thereby to form N⁻-type ion-implanted layer 2. Phosphorus is used as an impurity of the same conductivity type as substrate 1. Thereafter, surface 2a of ion-implanted layer 2 is washed, as is also the surface of P-type semiconductor substrate 3 of low specific resistance. The washed surface of layer 2 of substrate 1 and that of substrate 3 are then laid one on top of the other and physically bonded to each other, and thereafter are annealed at a temperature of 1,000°C or higher, to chemically strengthen the bonding therebetween. Finally, surface 1a (element formation surface) opposite to the bonding interface of substrate 1 is subjected to rough polishing and finish polishing, to obtain a bonded structure type semiconductor substrate as shown in Fig. 2.

The bonded structure type semiconductor substrate obtained as described above is utilized for, for example, an IGBT (insulated gate bipolar transistor) as shown in Fig. 3. In Fig. 3, reference numeral 7 denotes a P-type layer; 8, an N-type layer; 9, a gate; 10, a source (emitter); and 11, a drain (collector).

The critical problem as regards the bonded structure type semiconductor substrate described above is that the bonding is never complete; certain areas thereof remain unbonded. Within these unbonded areas, the resistance is locally increased, with the result that the characteristics of a semiconductor element are adversely influenced.

It was previously considered that unbonded areas resulted from the presence of dust on parts of a bonding surface. However, in recent years, as a result of improved precision in the detecting of unbonded areas by use of infrared-transparent imaging (see Japanese Patent Association Disclosure No. 85-6424), it has been revealed that unbonded areas can result from causes other than dust. (Hereinafter, an unbonded area will be referred to as a "micro void").

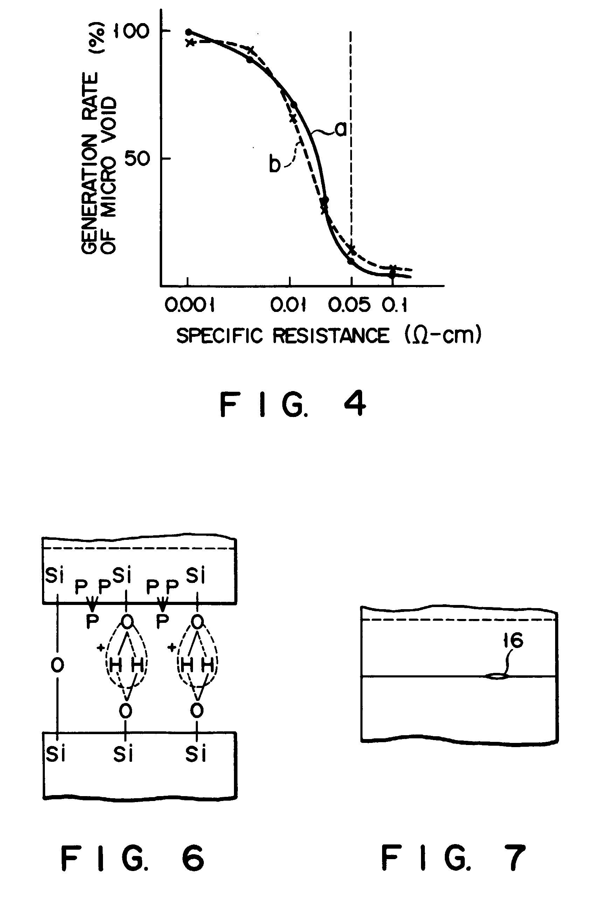

For example, it was found that micro voids were often formed during the annealing process for chemically increasing the bonding strength of the bonded structure. As a result of studies carried out to determine the mechanisms by which micro voids are generated, it has been found that the rate of generation of micro voids depends on the specific resistance of P⁺-type substrate 3, shown in Fig. 2, as indicated by curve a in the graph of Fig. 4. In particular, micro voids noticeably appear when the specific resistance of substrate 3 is 0.05 Ω·cm or less.

A bonded structure type semiconductor substrate in which layers respectively have different conductivity types, such as those in the N⁻-N⁺/P⁺ structure shown in Fig. 2, i.e., having a P⁻-P⁺/N⁺ structure, as shown in Fig. 5, can also be utilized as a substrate for an IGBT.

The generation of micro voids in the bonded structure type semiconductor substrate of the P⁻-P⁺/N⁺ structure was also examined, and it was found that the rate of generation of micro voids increased when the specific resistance of the N⁺-substrate was 0.05 Ω·cm or less. Such micro voids bring about a local increase in resistance, and in a polishing step or a device manufacturing step, can cause cracking of the bonded substrate. In the worst case, they can bring about the destruction of the element.

An N⁻-N⁺/P⁺ bonded structure type semiconductor substrate can also be formed by use of a method described in "Extended Abstracts of the 18th (1986 International) Conference on Solid State Devices and Materials, pp. 89 - 92; A. Nakagawa et al; Aug, 1986". However, in this method, after an N⁺-type layer and a P⁺-type layer are sequentially formed on an N⁺-type substrate, the surfaces of the P⁺-type layer and the surface of a P⁺-type substrate are bonded to each other.

That is, when this method is used, the problem of micro voids does not arise.

It is an object of the present invention to provide a bonded structure type semiconductor substrate in which no micro defect is formed at a bonding interface, even at high ion-implantation doses where micro voids would normally be expected.

According to the present invention, there is provided a method of manufacturing a bonded structure type semiconductor substrate, as defined in claim 1 below.

The temperature at which the first thermal treatment is performed falls within the range of 1,000 to 1,200°C. The first thermal treatment is preferably performed in an oxidizing atmosphere. The time for carrying out the first thermal treatment is not limited to any particular duration.

When the first and second semiconductor substrates are bonded, the to-be-bonded surfaces of the substrates are first preferably mirror-polished. The method of mirror-polishing can include optical polishing.

The surface roughness of the mirror-polished surface is preferably 50nm (500 Å) or less. It should be noted that "surface roughness" is given by a maximum height (Rmax) defined by JIS B-0601 (1982).

In accordance with the surface conditions of the first and second semiconductor substrates, the polished surfaces are preferably washed with water, a surfactant, an organic solvent, an acid solution, or the like, in order to remove contaminants (e.g. fine particules, absorbed ions, organic materials, inorganic material, and the like), grease, and any stain film. In the case of an Si substrate, the washing step is performed using a solution mixture of H₂0₂ and H₂SO₄, boiling aqua regia, and then an HF solution.

The substrates are then washed for several minutes with purified water and are then spin-dried at room temperature. This drying step aims to remove excess water and to leave water adsorbed in the mirror-polished surface of the substrate. For this reason, heat-drying at a temperature of 100°C or higher, at which almost all adsorbed water would be vaporized, must be avoided. The mirror-polished surfaces of the substrates are in contact with each other in a clean atmosphere of, for example, Class 1 or below, so that virtually no foreign substances lie therebetween, and are then annealed at a temperature of 200°C or higher. In the case of an Si substrate, the annealing temperature is preferably 1,000°C to 1,200°C.

According to the method described above, generation of micro voids can be suppressed by thermally treating the first semiconductor substrate before bonding. As a result, a bonded type semiconductor substrate can be obtained with a high yield, whereby semiconductor chips can subsequently be manufactured at low cost.

In the case of the present invention, a mechanism for suppressing generation of micro voids by the thermal treatment before bonding is not yet fully understood, but it can be supposed that the mechanism is based on the following reasons:

In the conventional method, when a substrate in which phosphorus ions are implanted and a substrate having a specific resistance of 0.05 Ω·cm are bonded to each other, since the phosphorus concentration on the surface of the ion-implanted layer is very high, a phosphorus impurity is precipitated on the surface during the thermal treatment after bonding, as is shown in Fig. 6. OH groups present on the substrate surface are bonded to each other, as is indicated by dotted curves, H₂O is eliminated, and the remaining ions are condensed like Si-O-Si. In this case, the eliminated H₂O, and the phosphorus impurity precipitated on the substrate surface react with each other during the thermal treatment after bonding, to generate a phosphoric acid gas or a phosphoric acid compound, thus forming micro voids 16, as shown in Fig. 7. Therefore, according to the method of the present invention, the thermal treatment is performed after ion implantation, and the impurity present on the substrate surface is diffused to decrease its concentration. Thus, if bonding is performed thereafter, and the thermal treatment is then performed, no phosphoric acid or the like are generated at the bonding interface, as a result of which, generation of micro voids can be prevented.

In view of the mechanism of micro void generation, if the amount of impurity ion-implanted in one substrate is small and the amount of impurity on the substrate surface is small, no micro voids should then be generated. In fact, if the dose of ion implantation is 5 ×10¹⁴ atm/cm² or less, no micro voids will be generated.

### Brief Description of the Drawings

Figs. 1 and 2 are sectional views respectively showing manufacturing processes of an N⁻-N⁺ /P⁺ bonded structure type semiconductor substrate, for explaining a conventional method and a method of the present invention;
Fig. 3 is a sectional view of an IGBT using the substrate shown in Fig. 2;
Fig. 4 is a graph showing a change in the rate of generation of micro voids as a function of a change in the specific resistance of a P⁺-type substrate;
Fig. 5 is a sectional view of an IGBT using a N⁻-N⁺/P⁺ bonded structure type substrate obtained according to the method of the present invention;
Figs. 6 and 7 are views for explaining a mechanism of micro void generation;
Fig. 8 is a graph showing a change in the rate of generation of micro voids as a function of a change in the specific resistance of a P⁺-type substrate, when using the method of the present invention;
Fig. 9 is a graph showing a change in the rate of generation of micro voids as a function of a change in the temperature at which a first thermal treatment is performed, when using the method of the present invention;
Fig. 10 is a graph comparing micro void generation rates in the case of the conventional method and of the method of the present invention;
Fig. 11 is a graph comparing percent defectives of cracking and destruction which occur when using a wafer manufacturing process according to the conventional method and the method of the present invention;
Fig. 12 is a graph comparing percent defectives of cracking and chipping-off of a wafer which occur when using a device manufacturing process according to the conventional method and the method of the present invention; and
Fig. 13 is a graph comparing resistance percent defectives of IGBTs obtained by use of the conventional method and the method of the present invention.

### Detailed Description of the Preferred Embodiments

The present invention will be described in detail by way of its examples.

### Example 1

Five types (20 wafers in each type) of low resistance P-type silicon wafers each having a diameter of 100 mm and respectively having specific resistances of 0.001, 0.005, 0.01, 0.05, and 0.1 Ω·cm (where a wafer having a specific resistance of 0.1 Ω·cm is a comparative example) were prepared as second semiconductor substrates 3, shown in Fig. 1. High resistance N-type silicon wafers having a diameter of 100 mm and a specific resistance of 62.5 Ω·cm were prepared as first semiconductor substrates 1. Phosphorus ions were implanted in each substrate 1 at an acceleration voltage of 40 keV and a dose of 2 × 10¹⁵ atm/cm², thereby forming ion-implanted layer 2. Thereafter, substrate 1 on which ion-implanted layer 2 was formed was annealed for one hour in an atmosphere having a gas mixture ratio of N₂/O₂ = 4/l at a temperature of 1,100°C, thereby diffusing the impurity on the surface of ion-implanted layer 2. The reason why the atmosphere contains O₂ is to prevent out-diffusion of phosphorus ions.

Then, the surface of ion-implanted layer 2 of each substrate 1 and the surface of each substrate 3 were mirror-polished to reduce the surface roughness to 50 nm (500 Å) or less. Thereafter, according to the surface conditions of the substrates, a treatment using a mixture of H₂O₂ and H₂SO₄ , boiling in aqua regia, and then a treatment using an HF solution were performed to remove grease and a stain film. Then, the substrates were washed for several minutes with purified water, and were spin-dried at room temperature.

Thereafter, the treated surfaces of substrates 1 and 3 were placed in contact with each other in a clean atmosphere of, for example, Class 1 or below, to bond them to each other. Then, the bonded structure was annealed for 2 hours in an N₂ atmosphere at a temperature of 1,000°C, whereby each of the bonded structure type substrates shown in Fig. 2 was obtained.

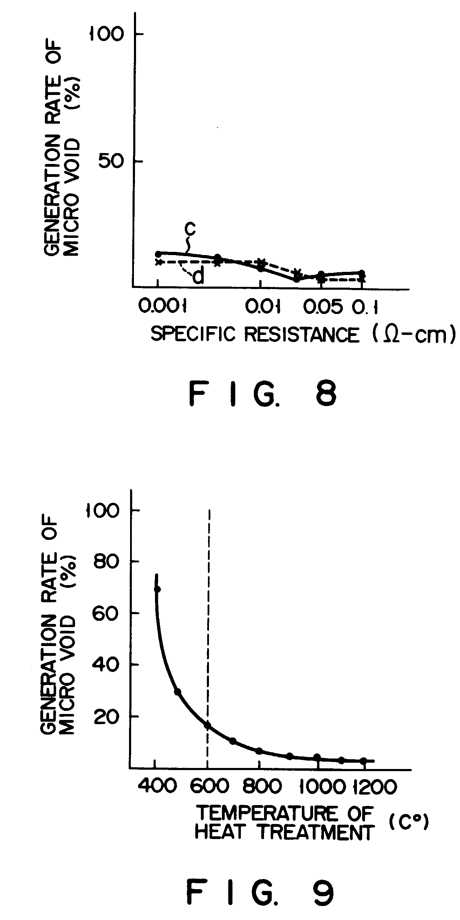

The rate of generation of micro voids in the bonded structure type substrate was determined by use of an infrared-transparent imaging method, the results being summarized in Fig. 8.

Solid curve c in the graph of Fig. 8 indicates dependency of the micro void generation rate (ordinate) on the specific resistance (abscissa) of the second substrate. As can be understood from a comparison of solid curve c in Fig. 8 and solid curve a in Fig. 4, according to the method of the present invention, the micro void generation rate can be greatly reduced.

### Example 2

Five types (10 wafers in each type) of low resistance N-type silicon wafers each having a diameter of 100 mm and respectively having specific resistances of 0.001, 0.005, 0.01, 0.05, and 0.1 Ω·cm (where a wafer having a specific resistance of 0.1 Ω·cm is a comparative example) were prepared as semiconductor substrates 13, shown in Fig. 5. High resistance P-type silicon wafers each having a diameter of 100 mm and a specific resistance of 25 Ω·cm were prepared as substrates 11. Phosphorus ions were implanted in each substrate 11 at an acceleration voltage of 40 keV and a dose of 1 × 10¹⁵ atm/cm², thereby forming ion-implanted layer 12. Thereafter, each substrate 11 on which ion-implanted layer 12 was formed was thermally treated, following the same procedures as in Example 1, to diffuse the impurity on layer 12. Thereafter, following the same procedures as in Example 1, each of the bonded structure type substrates shown in Fig. 5 was obtained.

The rate of generation of micro voids in the bonded structure type substrates was determined in the same manner as in Example 1, with results similar thereto being obtained, as indicated by broken curve d in Fig. 8.

### Example 3

Low resistance P-type silicon wafers each having a diameter of 100 mm and a specific resistance of 0.005 Ω·cm were prepared as semiconductor substrates 3, shown in Fig. 1, and nine high resistance N-type silicon wafers each having a diameter of 100 mm and a specific resistance of 62.5 Ω·cm were prepared as substrates 1. Phosphorus ions were implanted in each substrate 1 at an acceleration voltage of 40 keV and at a dose of 2 × 10¹⁵ atm/cm², and the annealing temperature after implantation was changed, at 50°C intervals, to within the range of 400°C to 1,200°C, (the annealing time and the atmosphere were the same as those in Example 1). Thereafter, substrates 1 and 2 were bonded, following the same procedures as in Example 1, and the bonded structures were annealed for 2 hours in an N₂ atmosphere at a temperature of 1,100°C. The dependency of the generation of microvoids on annealing temperature after implantation was then examined.

As is shown in Fig. 9, if the annealing temperature is 600°C or higher, generation of micro voids can be suppressed.

It was found that the annealing time could be sufficiently 30 minutes or more. Rapid annealing, in which instantaneous annealing (1,100°C for 10 sec) is performed, can also reduce micro voids. Therefore, an optimal annealing time depends on an annealing method.

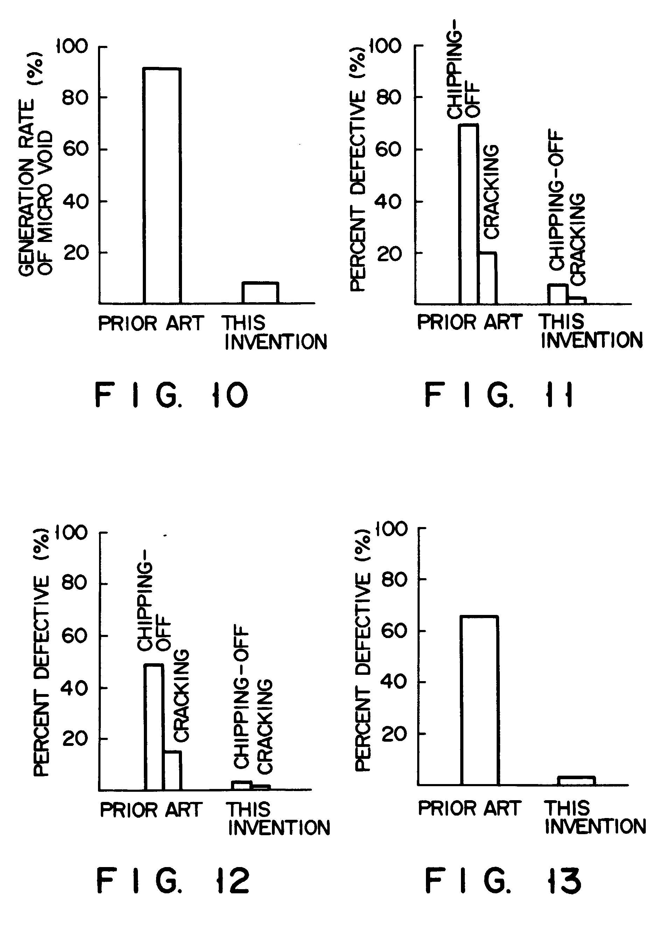

Fig. 10 is a graph which averages the results in Examples 1 to 3 and shows micro void generation rates in the case of the conventional method and of the method of the present invention, for the sake of comparison. As can be seen from Fig. 10, according to the method of the present invention, generation of micro voids is noticeably suppressed. This effect can greatly improve a substrate crack defect in a manufacturing process of a bonded type wafer or in a device manufacturing process, and a resistance defect ratio in an IGBT element.

In Fig. 11, chipping-off and crack percent defectives of bonded type wafers in the manufacturing process are compared.

In Fig. 12, chipping-off and crack percent defectives of bonded type wafers in the device manufacturing process are compared.

In these processes, since a pressure or thermal stress is applied to a wafer, conventional wafers are cracked or destroyed due to the presence of micro voids. However, according to the present invention, since generation of micro voids can be prevented, cracking and chipping-off of wafers can be eliminated.

In Fig. 13, resistance percent defectives in IGBT elements are compared.

Even in bonded type wafers in which defects such as cracking or chipping-off do not occur during the machining process or the device manufacturing process, micro voids may still remain. When the resistances of elements were measured, resistance defects were locally found However, according to the present invention, the resistance defect ratio can also be greatly improved.

Data shown in Figs. 11 to 13 were obtained using an N-type silicon wafer, having a diameter of 100 mm and a specific resistance of 62.5 Ω·cm, as a first semiconductor substrate, and a P-type silicon wafer, having a diameter of 100 mm and a specific resistance of 0.015 Ω·cm, as a second semiconductor substrate. Conditions for thermal treatment and bonding were substantially the same as those in Example 1, except that data for the conventional method were obtained without thermal treatment being performed before bonding.

## Claims

1. A method of manufacturing a bonded structure type semiconductor substrate, comprising the steps of ion-implanting phosphorus into a first semiconductor substrate (1) of n-type conductivity, to form an n-type ion-implanted layer (2) in a surface region of said first semiconductor substrate (1); causing said first semiconductor substrate (1) to be subjected to a first thermal treatment; bonding a p-type surface of a second p-type semiconductor substrate (3) to the n-type surface of said ion-implanted layer, and performing a second thermal treatment after the first and second semiconductor substrates have been bonded, wherein the ion-implantation is carried out at a dose of more than 5x10¹⁴ atom/cm², in that the first thermal treatment on the first semiconductor substrate is within the temperature range of 1000° - 1200°C, to decrease the concentration of phosporus in the surface portion of the ion-implanted layer and to reduce or prevent formation of microvoids at the interface of the bonded semiconductor substrates (1,3), and in that the second semiconductor substrate has a specific resistance of not more than 0.05 ohm.cm.

2. A method according to claim 1, characterized by further comprising the step of mirror-polishing to-be-bonded surfaces of said first and second semiconductor substrates (1, 3), to obtain a surface roughness of 50nm (500Å).

3. A method according to any of claims 1 or 2, characterized in that the temperature of the second thermal treatment is 200°C or higher.

4. A method according to claim 3, characterized in that the temperature of the second thermal treatment falls within the range of 1,000° to 1,200°C.

## Patentansprüche

1. Verfahren zum Herstellen eines Halbleitersubstrates eines verbundenen Strukturtyps mit den folgenden Schritten: Ionenimplantieren von Phosphor in ein erstes Halbleitersubstrat (1) einer n-Typ-Leitfähigkeit, um eine n-Typ-Ionenimplantationsschicht (2) in einem Oberflächenbereich des ersten Halbleitersubstrates (1) zu bilden, Veranlassen des ersten Halbleitersubstrates (1), einer ersten Wärmebehandlung unterworfen zu sein, Verbinden einer p-Typ-Oberfläche eines zweiten p-Typ-Halbleitersubstrates (3) mit einer n-Typ-Oberfläche der Ionenimplantationsschicht und Durchführen einer zweiten Wärmebehandlung, nachdem die ersten und zweiten Halbleitersubstrate verbunden sind, wobei die Ionenimplantation bei einer Dosis von mehr als 5 x 10¹⁴ Atomen/cm² ausgeführt wird, wobei die erste Wärmebehandlung auf dem ersten Halbleitersubstrat in dem Bereich von 1000 bis 1200°C ist, um die Konzentration von Phosphor in dem Oberflächenteil der ionenimplantierten Schicht zu vermindern und eine Bildung von Mikrohohlräumen an der Zwischenfläche der verbundenen Halbleitersubstrate (1, 3) zu reduzieren oder zu verhindern, und wobei das zweite Halbleitersubstrat einen spezifischen Widerstand von nicht mehr als 0,05 Ohm · cm hat.

2. Verfahren nach Anspruch 1, gekennzeichnet durch den Schritt eines Spiegelpolierens von zu verbindenden Oberflächen der ersten und zweiten Halbleitersubstrate (1, 3), um eine Oberflächenrauhigkeit von 50 nm (500 Å) zu erhalten.

3. Verfahren nach einem der Ansprüche 1 oder 2, dadurch gekennzeichnet, daß die Temperatur der zweiten Wärmebehandlung 200°C oder höher ist.

4. Verfahren nach Anspruch 3, dadurch gekennzeichnet, daß die Temperatur der zweiten Wärmebehandlung in den Bereich von 1000 bis 1200°C fällt.

## Revendications

1. Procédé de fabrication d'un substrat à semiconducteur du type à structure liée comprenant les étapes de : implantation ionique de phosphore dans un premier substrat semiconducteur (1) d'une conductivité de type N afin de former une couche implantée ioniquement de type N (2) dans une région de surface dudit premier substrat semiconducteur (1) ; soumission dudit premier substrat semiconducteur (1) a un premier traitement thermique ; liaison d'une surface de type P d'un second substrat semiconducteur de type P (3) à la surface de type N de ladite couche implantée ioniquement ; et réalisation d'un second traitement thermique après que les premier et second substrats semiconducteurs ont été liés, dans lequel l'implantation ionique est mise en oeuvre à une dose supérieure à 5 x 10¹⁴ atomes/cm² ; en ce que le premier traitement thermique sur le premier substrat semiconducteur est dans la plage de températures de 1000°C à 1200°C afin de diminuer la concentration de phosphore dans la partie de surface de la couche implantée ioniquement et afin de réduire ou d'empêcher la formation de microvides au niveau de l'interface des substrats semiconducteurs liés (1, 3) ; et en ce que le second substrat semiconducteur présente une résistance spécifique non supérieure à 0,05 ohm.cm.

2. Procédé selon la revendication 1, caractérisé en ce qu'il comprend en outre l'étape de polissage miroir de surfaces à lier desdits premier et second substrats semiconducteurs (1, 3) afin d'obtenir une rugosité de surface de 50 nm (500Å).

3. Procédé selon l'une quelconque des revendications 1 ou 2, caractérisé en ce que la température du second traitement thermique est de 200°C ou plus.

4. Procédé selon la revendication 3, caractérisé en ce que la température du second traitement thermique tombe dans la plage de 1000°C a 1200°C.
